# EUROPEAN PATENT APPLICATION

(11) **EP 4 597 848 A1**
(43) Date of publication of application: **06.08.2025**
(21) Application number: 25152547.3
(22) Date of filing: 17.01.2025
(51) Int. Cl.: H03M 7/30, H04N 19/182

(54) **COMPRESSION APPARATUS, COMPRESSION METHOD, AND PROGRAM**

(30) Priority: 05.02.2024 JP 2024015836
(71) Applicant: Yokogawa Electric Corporation, Tokyo 180-8750 (JP)
(72) Inventor: OCHIAI, Satoru, Musashino-shi, Tokyo, 180-8750 (JP); LIU, Changlin, Shanghai, 200051 (CN)
(74) Representative: Hoffmann Eitle

(57) **Abstract**

(Solution) Provided is a compression apparatus including: a decision unit which decides, based on a variation trend of data in a data string, a bit width indicating a deviation of data; a calculation unit which calculates, with the bit width, deviations of respective pieces of data in a data group obtained by dividing the data string; a generation unit which generates a frame including: the deviations of the respective pieces of data in the data group; and information indicating the bit width; and a specification unit which specifies, from the data string, at least one continuous piece of data, a deviation of which falls within the bit width, as the data group.

## Description

### BACKGROUND

### 1. TECHNICAL FIELD

The present invention relates to a compression apparatus, a decompression apparatus, a compression method, a decompression method, and a program.

### 2. RELATED ART

Patent document 1 describes that "a plurality of measurement values are converted and compressed, stored together in a message, and transmitted to a processing unit" (claim 1) or the like.

### Prior art documents

### Patent document

Patent document 1: Japanese Patent No. 7181674

### SUMMARY

A first aspect of the present invention provides a compression apparatus including: a decision unit which decides, based on a variation trend of data in a data string, a bit width indicating a deviation of data; a calculation unit which calculates, with the bit width, deviations of respective pieces of data in a data group obtained by dividing the data string; and a generation unit which generates a frame including: the deviations of the respective pieces of data in the data group; and information indicating the bit width. The variation trend of data may be a variation trend of data value, and for example, it may be a number of at least one piece of data continuously appearing, a deviation of which falls within a preset range, or may be a compression ratio calculated using this number.

The apparatus may further include a specification unit which specifies, from the data string, at least one continuous piece of data, a deviation of which falls within the bit width, as the data group.

In the apparatus, the generation unit may generate the frame further including at least one of: a number of at least one piece of data in the data group; or information indicating an end position of a deviation at an end among the deviations of the respective pieces of data.

In the apparatus, a reference value for deviations of respective pieces of data in a data group may be a maximum value or a minimum value among data values in the data group.

In the apparatus, which includes the specification unit, according to any of the above descriptions, the specification unit may specify, in order starting from a side of a head of the data string, unspecified pieces of data which have not been specified as the data group, as a new data group.

In the apparatus, the specification unit may specify an unspecified piece of data closest to the head in the data string to a piece of data, a deviation of which falls within the bit width, closest to an end, as the new data group.

In the apparatus in which the unspecified piece of data closest to the head in the data string to the piece of data, the deviation of which falls within the bit width, closest to the end, are specified as the new data group, the specification unit may specify at least one piece of data, a number of which is equal to or smaller than a preset reference number, as the data group. The reference number may be a maximum value for a case where a value equal to or greater than 0 is represented by an integer number of at least one bit.

In the apparatus in which the unspecified piece of data closest to the head in the data string to the piece of data, the deviation of which falls within the bit width, closest to the end, are specified as the new data group, the generation unit may generate another frame including a number of at least one piece of data in one data group being the data group, and the information indicating the bit width and not including deviations of respective pieces of data, and generate, in response to an instruction signal from an outside, the frame including: deviations of respective pieces of data in the one data group; and the information indicating the bit width.

In the apparatus in which the unspecified piece of data closest to the head in the data string to the piece of data, the deviation of which falls within the bit width, closest to the end, are specified as the new data group, in response to the data group including only a single piece of data being specified, the generation unit may generate, as a first frame different from the frame, the first frame including: a value of the single piece of data; and identification information of the first frame.

In the apparatus, which includes the specification unit, according to any of the above descriptions, in response to pieces of data having a same value continuing in the data string, the specification unit may specify, as the data group, the pieces of data continuing, and in response to continuous pieces of data having a same value being specified as the data group, the generation unit may generate, as a second frame different from the frame, the second frame including: values of the continuous pieces of data having the same value; a number of at least one piece of data in the data group; and identification information of the second frame.

In the apparatus, which includes the specification unit, according to any of the above descriptions, the decision unit may decide the bit width for each data group.

In the apparatus, the specification unit: may specify, for each of a plurality of bit width candidates, at least one continuous piece of data, a deviation of which falls within the bit width candidate, as a data group candidate; and specify the data group candidate, for which a compression ratio for a case where the frame is generated is smallest, among a plurality of data group candidates including the data group candidate, as the data group.

In the apparatus, the decision unit may decide a bit width candidate, for which a compression ratio for a case where the frame is generated from a corresponding data group candidate being the data group candidate is smallest, among the plurality of bit width candidates, as the bit width, and the specification unit may specify the data group candidate corresponding to the bit width candidate decided as the bit width among the plurality of data group candidates, as the data group.

In the apparatus according to any of the above descriptions, the calculation unit may calculate, as the deviations of the respective pieces of data in the data group, deviations of respective pieces of data obtained through division by a preset natural number, and the generation unit may generate a frame including: the natural number; the deviations of the respective pieces of data in the data group; and the information indicating the bit width.

The apparatus according to any of the above descriptions may further include an acquisition unit which acquires the data string in chronological order for each pixel from a plurality of pieces of image data captured in order.

In the apparatus, the plurality of pieces of image data may be images captured by a fixed point camera.

In the apparatus, the fixed point camera may be a thermography camera.

The apparatus according to any of the above descriptions may further include a transmission unit which transmits the frame.

In the apparatus, the transmission unit may transmit, to an apparatus to which the frame is to be transmitted, information indicating a configuration of the frame.

A second aspect of the present invention provides a decompression apparatus including: an acquisition unit which acquires a frame including: a deviation data string indicating a deviation of at least one piece of data; and information indicating a bit width for deviation; an extraction unit which extracts, based on the information indicating the bit width, deviations of respective pieces of data indicated by the bit width, from the deviation data string; and a calculation unit which calculates values of respective pieces of data from deviations of respective pieces of data.

A third aspect of the present invention provides a compression method including: deciding, based on a variation trend of data in a data string, a bit width indicating a deviation of data; calculating, with the bit width, deviations of respective pieces of data in a data group obtained by dividing the data string; and generating a frame including: the deviations of the respective pieces of data in the data group; and information indicating the bit width.

A fourth aspect of the present invention provides a decompression method including: acquiring a frame including: a deviation data string indicating a deviation of at least one piece of data; and information indicating a bit width for deviation; extracting, based on the information indicating the bit width, deviations of respective pieces of data indicated by the bit width, from the deviation data string; and calculating values of respective pieces of data from deviations of respective pieces of data.

A fifth aspect of the present invention provides a program which, when executed by a computer, causes the computer to function as: a decision unit which decides, based on a variation trend of data in a data string, a bit width indicating a deviation of data; a calculation unit which calculates, with the bit width, deviations of respective pieces of data in a data group obtained by dividing the data string; and a generation unit which generates a frame including: the deviations of the respective pieces of data in the data group; and information indicating the bit width.

A sixth aspect of the present invention provides a program which, when executed by a computer, causes the computer to function as: a decompression apparatus including: an acquisition unit which acquires a frame including: a deviation data string indicating a deviation of at least one piece of data; and information indicating a bit width for deviation; an extraction unit which extracts, based on the information indicating the bit width, deviations of respective pieces of data indicated by the bit width, from the deviation data string; and a calculation unit which calculates values of respective pieces of data from deviations of respective pieces of data.

The summary clause does not necessarily describe all necessary features of the embodiments of the present invention. The present invention may also be a sub-combination of the features described above.

### BRIEF DESCRIPTION OF THE DRAWINGS

FIG. 1 shows a communication system 1 according to an embodiment.
FIG. 2 shows input data, data groups obtained by dividing the input data, a frame generated for each of the data groups, and a configuration of the frame.
FIG. 3 shows operation of a compression apparatus 2.
FIG. 4 shows exemplary operation of a specification unit 22.
FIG. 5 shows exemplary operation of a calculation unit 24.
FIG. 6 shows exemplary operation of a generation unit 25.
FIG. 7 shows operation of a decompression apparatus 3.
FIG. 8 shows pixels in an image.
FIG. 9 shows a data string acquired from image data captured by a thermography camera.
FIG. 10 shows a result of estimation by a computing unit 34.
FIG. 11 shows an example of a computer 1200 in which a plurality of aspects of the present invention may be entirely or partially embodied.

### DESCRIPTION OF EXEMPLARY EMBODIMENTS

Hereinafter, embodiments of the present invention will be described. However, the following embodiments are not for limiting the invention according to the claims. In addition, not all of the combinations of features described in the embodiments are essential to the solution of the invention.

### (Communication system 1)

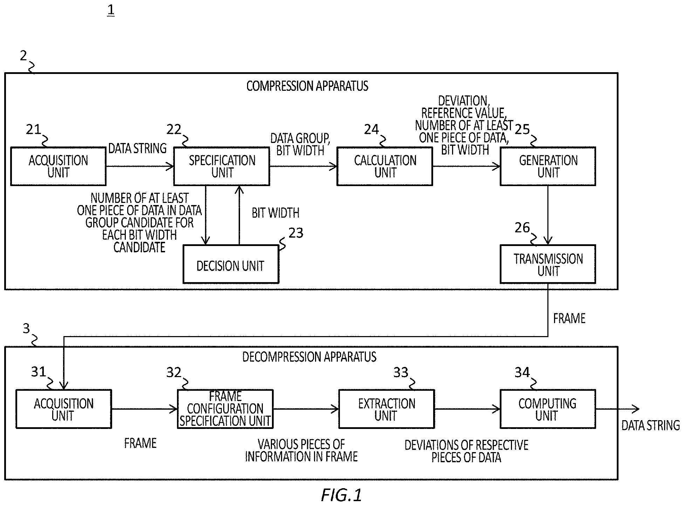

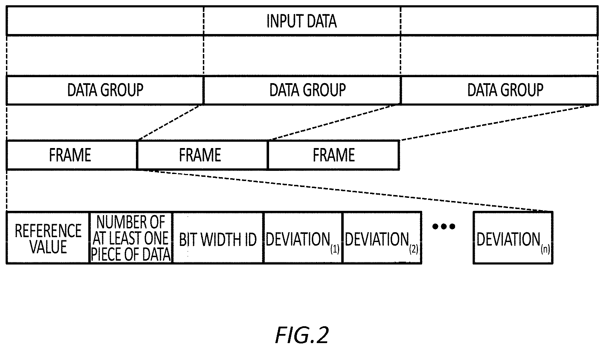

FIG. 1 shows a communication system 1 according to the present embodiment. The communication system 1 has a compression apparatus 2 and a decompression apparatus 3. It should be noted that, although details will be described later, the compression apparatus 2 according to the present embodiment compresses pieces of data into a frame for each of data groups obtained by dividing a data string. The frame according to the present embodiment may include, for example, a deviation data string in which deviations of respective pieces of data included in a data group are arranged, a reference value for deviation, a number of at least one piece of data included in the data group, and an identification number of a bit width indicating a deviation, where the bit width indicating the deviation is also referred to as a bit width for deviation, and the identification number of the bit width is also referred to as a bit width ID (see FIG. 2 which will be described later). According to such a frame, in the decompression apparatus 3, the deviations of the respective pieces of data, a number of which corresponds to the number of at least one piece of data, are extracted by dividing the deviation data string by the bit width for deviation, and respective data values are calculated by adding the deviations to the reference value.

### ((Compression apparatus 2))

The compression apparatus 2 has an acquisition unit 21, a specification unit 22, a decision unit 23, a calculation unit 24, a generation unit 25, and a transmission unit 26. The compression apparatus 2 may be placed near a sensor placed in equipment such as a plant, or the like. Examples of the plant include, in addition to an industrial plant such as a chemical plant or a bio plant, a plant for managing and controlling a well site such as a gas field or an oil field and its surrounding area, a plant for managing and controlling power generation such as hydraulic, thermal, or nuclear power generation, a plant for managing and controlling energy harvesting from solar power, wind power, or the like, a plant for managing and controlling water and sewerage, a dam, or the like, and others.

### ((((Acquisition unit 21)))

The acquisition unit 21 acquires input data. The acquisition unit 21 may acquire the input data from an external device. The acquisition unit 21 may acquire the input data through wired communication, or may acquire the input data through wireless communication. The input data may be digital data, or may be analog data. The acquisition unit 21 may acquire a data string of the digital data from the acquired input data. The acquisition unit 21 may supply the acquired data string to the specification unit 22. The data string may include a plurality of pieces of data arranged, and each piece of data may indicate one data value.

Here, the external device may be a sensor (for example, acceleration sensor, pressure sensor, temperature sensor, vibration sensor, or the like), or may be a repeater or a gateway apparatus interposed between the sensor and the compression apparatus 2. In these cases, the input data may be measurement data, and the acquisition unit 21 may acquire a data string in which periodically measured measurement data are arranged. It should be noted that the external device may be another apparatus such as a computing apparatus or an image capturing apparatus. If the external device is a computing apparatus, the input data may indicate a physical amount calculated from the measurement data obtained by the sensor and being different from the measurement data, or may indicate status information such as a state index value. If the external device is an image capturing apparatus, the input data may be image data. The external device and the acquisition unit 21 may be detachably provided.

### ((((Specification unit 22)))

The specification unit 22 specifies, from the data string, at least one continuous piece of data, a deviation of which falls within the bit width for deviation, as the data group.

Here, the at least one continuous piece of data may be a single piece of data, or may be a plurality of continuous pieces of data. The bit width for deviation may be a bit width representing a deviation of data, and may be, for example, 6 bits or 7 bits. If the bit width for deviation is 6 bits, a deviation of 0 to 63 is indicated, and if the bit width for deviation is 7 bits, a deviation of 0 to 127 is indicated. The deviation of data may be a difference between the reference value and a data value. The reference value will be described later in detail.

The specification unit 22 may specify, in order starting from a side of a head of the data string, unspecified pieces of data which have not been specified as the data group, as a new data group. For example, when having already specified first to k-th pieces of data in the data string as the data group, the specification unit 22 may specify at least one continuous piece of data, which is (k + 1)-th and subsequent pieces of data, as the new data group.

The specification unit 22 may specify an unspecified piece of data closest to the head in the data string to a piece of data, a deviation of which falls within the bit width for deviation, closest to an end, as the new data group. That is, the specification unit 22 may specify all of continuous pieces of data, deviations of which fall within the bit width for deviation, among the unspecified pieces of data, as the data group.

It is to be noted that, if a number of the continuous pieces of data, the deviations of which fall within the bit width for deviation, exceeds a preset reference number, the specification unit 22 may specify at least one piece of data, a number of which is equal to or smaller than the reference number, as the data group. For example, if deviations of first to k-th continuous pieces of data among the unspecified pieces of data fall within the bit width for deviation and if k exceeds a reference number kₛ, the specification unit 22 may specify first to kₛ-th pieces of data as the data group. In this case, (kₛ + 1)-th and subsequent pieces of data will be unspecified pieces of data.

The reference number may be a maximum value for a case where a value equal to or greater than 0 is represented by an integer number of at least one bit. For example, the reference number may be 31, which is a maximum value represented by 5 bits, may be 63, which is a maximum value represented by 6 bits, may be 127, which is a maximum value represented by 7 bits, may be 255, which is a maximum value represented by 8 bits, or may be 511, which is a maximum value represented by 9 bits. The reference number may be arbitrarily set by the decompression apparatus 3 or the like.

The specification unit 22 may specify candidates for the data group (also referred to as data group candidates) for each of a plurality of candidates for the bit width for deviation (also referred to as bit width candidates) by using the approach described above, and specify any one of the data group candidates as a final data group. That is, the specification unit 22 may specify, for each of the plurality of bit width candidates, at least one continuous piece of data, a deviation of which falls within the bit width candidate, as a data group candidate, and specify any one of a plurality of data group candidates as the data group. The specification unit 22 may specify the data group candidate, for which a compression ratio for a case where the frame (in the present embodiment, for example, the frame including a deviation indicated by the bit width, which is the bit width candidate, for each piece of data) is generated from the data group candidate is smallest, among the plurality of data group candidates, as the data group. For example, the specification unit 22 may specify the data group candidate, which corresponds to the bit width candidate decided as the bit width for deviation by the decision unit 23 which will be described later (in the present embodiment, for example, the bit width candidate for which the compression ratio is smallest), among the plurality of data group candidates, as the data group.

The compression ratio may be a compression ratio for a case where the data group candidate is compressed and converted into the frame, or may be a ratio of an amount of data of the frame to an amount of data of the data group candidate. In the frame according to the present embodiment, a bit length of deviation and a number of at least one deviation vary depending on the bit width for deviation, and in the data group according to the present embodiment, the number of at least one piece of data varies depending on the bit width for deviation, so the compression ratio may differ from one bit width candidate to another.

The specification unit 22 may supply the decision unit 23 with the number of at least one piece of data in the data group candidate for each of the bit width candidates, and specify the data group candidate corresponding to any one of the bit width candidates decided as the bit width for deviation by the decision unit 23, as the data group. The specification unit 22 may supply the calculation unit 24 with the specified data group and the bit width for deviation. It should be noted that, if data group candidates for which the compression ratio is smallest are specified as the data groups in order from the data string, to generate a plurality of frames, a total length of the generated plurality of frames may be smallest. A value of the bit width candidate may be arbitrarily set by the decompression apparatus 3 or the like.

### ((((Decision unit 23)))

The decision unit 23 decides the bit width indicating the deviation of data based on a variation trend of data in the data string. The variation trend of data may be a variation trend of data value, and for example, it may be a number of at least one piece of data continuously appearing, a deviation of which falls within a preset range, or may be a compression ratio calculated using this number.

The decision unit 23 may decide the bit width for deviation for each of the data groups. For example, the decision unit 23 may decide a first bit width for deviation for one data group, and decide a second bit width for deviation for another data group.

If the data group candidate is specified for each of the plurality of bit width candidates by the specification unit 22, the decision unit 23 may decide the bit width candidate, for which the compression ratio for a case where the frame (in the present embodiment, for example, the frame including the deviation indicated by the bit width, which is the bit width candidate, for each piece of data) is generated from a corresponding data group candidate is smallest, among the plurality of bit width candidates, as the bit width for deviation. For example, the decision unit 23 may calculate the compression ratio for each of the bit width candidates based on a number of at least one bit of the bit width candidate supplied from the specification unit 22 and on the number of at least one piece of data in the corresponding data group candidate. In the present embodiment, for example, the decision unit 23 may calculate the compression ratio for each of the bit width candidates using Equation 1 described below, and decide the bit width candidate for which the compression ratio is smallest, as the bit width for deviation. Compression ratio = amount of data of frame / amount of data of data group candidate = (number of at least one bit of reference value + number of at least one bit indicating number of at least one piece of data + number of at least one bit indicating bit width ID + number of at least one bit of bit width candidate × number of at least one piece of data) / (number of at least one bit of data value × number of at least one piece of data) ...

In the equation, the number of at least one bit of the reference value is the number of at least one bit previously decided to indicate the reference value for the deviation of data, and may be, for example, the same as the number of at least one bit of each piece of data included in the data string (in the present embodiment, for example, 16 bits), but may be another number of at least one bit. The number of at least one bit indicating the number of at least one piece of data is the number of at least one bit previously decided to indicate the number of at least one piece of data included in the data group candidate, and for example, may be decided to be any one of 5 bits to 9 bits according to an upper limit of the number of at least one piece of data. The number of at least one bit indicating the bit width ID is the number of at least one bit previously decided to indicate the bit width ID previously associated with the bit width candidate, and for example, may be decided to be any one of 2 bits to 4 bits. The number of at least one bit of the reference value, the number of at least one bit indicating the number of at least one piece of data, the number of at least one bit indicating the bit width ID, and the like may be set to any value by the decompression apparatus 3 or the like. The number of at least one bit of the bit width candidate and the number of at least one piece of data may be the number of at least one bit of the bit width candidate supplied from the specification unit 22 and the number of at least one piece of data in the data group candidate.

If compression ratios calculated for the plurality of bit width candidates are the same, the decision unit 23 may decide any bit width candidate as the bit width for deviation. For example, among the plurality of bit width candidates for which the compression ratios are the same, the decision unit 23 may decide the largest bit width candidate as the bit width for deviation, or may decide the smallest bit width candidate as the bit width for deviation.

The decision unit 23 may supply the decided bit width for deviation to the specification unit 22. As a result, as described above, the specification unit 22 may specify, as the data group, the data group candidate corresponding to the bit width for deviation, and the bit width for deviation and the data group may be supplied from the specification unit 22 to the calculation unit 24.

### ((((Calculation unit 24)))

The calculation unit 24 calculates, with the bit width for deviation, the deviations of the respective pieces of data in the data group obtained by dividing the data string. The calculation unit 24 may calculate the deviations in binary form. The calculation unit 24 may calculate the deviations for the respective pieces of data in the data group supplied from the specification unit 22. The reference value for the deviations may be a value of any one of the pieces of data in the data group (for example, a value of immediately preceding piece of data, or a representative value for data values in the data group), or may be a predetermined fixed value. The reference value for the deviations may be a value different from one data group to another. In the present embodiment, for example, the reference value for the deviations of the respective pieces of data in the data group is a maximum value or a minimum value among the data values in the data group. The calculation unit 24 may specify the maximum value or the minimum value in the data group and use it as the reference value, and calculate the deviations from the reference value for the respective pieces of data in the data group. The calculation unit 24 may calculate the deviations by subtracting one of the reference value or the data values from another. The calculation unit 24 may supply the calculated deviations to the generation unit 25 in order. The calculation unit 24 may further supply the generation unit 25 with the bit width for deviation, the reference value for deviation, and the number of at least one piece of data in the data group.

### ((((Generation unit 25)))

The generation unit 25 generates the frame. The generation unit 25 may generate the frame for each of the data groups. The frame may include the deviations of the respective pieces of data in the data group, and the bit width ID of the bit width for deviation, and may further include the reference value for deviation and the number of at least one piece of data in the data group. For example, various pieces of information in the frame may be arranged in the following order from the side of the head: the reference value for deviation; the number of at least one piece of data in the data group; the bit width ID for deviation; and the deviations of the respective pieces of data. The reference value and the deviations may be indicated with or without signs, or may be indicated using single-precision or double-precision floating points. The deviations of the respective pieces of data may be concatenated one after the other to form the deviation data string. The bit width ID of the bit width for deviation may be one example of information indicating the bit width for deviation, and may be the bit width ID associated with the bit width candidate decided as the bit width for deviation.

The generation unit 25 may generate the frame in binary form, or may generate the frame in hexadecimal form by converting a binary frame into hexadecimal. The generation unit 25 may supply the generated frame to the transmission unit 26.

When generating the frame according to the present embodiment, the generation unit 25 may further generate information indicating a configuration of the frame (also referred to as frame configuration information). The frame configuration information may be the information indicating the configuration of the frame according to the present embodiment, that is, information indicating that the frame includes the reference value for deviation, the number of at least one piece of data in the data group, the bit width ID for deviation, and the deviation data string in this order, and may be information further indicating the number of at least one bit of the reference value for deviation, the number of at least one bit of the number of at least one piece of data in the data group, and the number of at least one bit of the bit width ID for deviation. The generation unit 25 may supply the generated frame configuration information to the transmission unit 26.

It should be noted that, in the frame according to the present embodiment, the configuration of the frame is the same regardless of the bit width for deviation or the number of at least one piece of data included in the data group, so the generation unit 25 only needs to supply the frame configuration information to the transmission unit 26 only once unless it generates a frame with another configuration. If a pattern of the frame configuration information is previously determined between the compression apparatus 2 and the decompression apparatus 3, the generation unit 25 may supply, as the frame configuration information, the transmission unit 26 with identification information corresponding to the pattern.

### ((((Transmission unit 26)))

The transmission unit 26 transmits the generated frame. The transmission unit 26 may transmit the frame to the decompression apparatus 3. The transmission unit 26 may transmit the frame through wired communication, or may transmit the frame through wireless communication. The transmission unit 26 may perform transmission by using a general purpose line (for example, a public line such as LTE or ETHERNET (registered trademark)). The transmission unit 26 may concatenate the plurality of frames (for example, all frames generated from the data string) to generate a compressed object, and transmit the compressed object to the decompression apparatus 3. A cycle in which the frame is transmitted by the transmission unit 26 may be longer than a cycle in which the input data is acquired by the acquisition unit 21 (for example, a cycle in which measurement is performed by a sensor connected to the acquisition unit 21).

When transmitting the frame according to the present embodiment, the transmission unit 26 may further transmit the frame configuration information to the decompression apparatus 3. Before transmitting the frame, the transmission unit 26 may transmit the frame configuration information to the decompression apparatus 3. As long as the frame according to the present embodiment is transmitted, a configuration of each frame is the same regardless of the bit width for deviation or the number of at least one piece of data included in the data group, so the transmission unit 26 only needs to transmit the frame configuration information to the decompression apparatus 3 only once unless it transmits a frame with another configuration.

### ((Decompression apparatus 3))

The decompression apparatus 3 is one example of an apparatus to which the frame is to be transmitted, and has an acquisition unit 31, a frame configuration specification unit 32, an extraction unit 33, and a computing unit 34. The decompression apparatus 3 may be placed at a position away from the compression apparatus 2, and for example, may be placed in a management room of the equipment, or the like.

### (((Acquisition unit 31)))

The acquisition unit 31 acquires the frame including the deviation data string indicating a deviation of at least one piece of data, and the bit width ID. The acquisition unit 31 according to the present embodiment receives the frame from the compression apparatus 2, but may acquire the frame by using another approach such as reading the frame stored in a recording medium (not shown). The acquisition unit 31 may receive the frames as the compressed object obtained by concatenating the plurality of frames. The acquisition unit 31 may supply the acquired frames to the frame configuration specification unit 32 in order. When having received the frame configuration information prior to receiving the frame, the acquisition unit 31 may supply the frame configuration information to the frame configuration specification unit 32.

### (((Frame configuration specification unit 32)))

The frame configuration specification unit 32 specifies the configuration of the frame based on the frame configuration information. The frame configuration specification unit 32 may extract the various pieces of information included in the frame (in the present embodiment, for example, the reference value for deviation, the number of at least one piece of data in the data group, the bit width ID for deviation, and the deviation data string), based on a result of specification. If the frame is generated in hexadecimal form, the frame configuration specification unit 32 may convert the frame into a binary frame, and then extract the various pieces of information included in the frame. The frame configuration specification unit 32 may supply the extracted various pieces of information to the extraction unit 33.

### (((Extraction unit 33)))

The extraction unit 33 extracts, based on the bit width ID, the deviations of the respective pieces of data indicated by the bit width for deviation, from the deviation data string. The extraction unit 33 may specify bit width for deviation corresponding to the bit width ID, and extract deviations of the bit width from the deviation data string. A number of the extracted deviations may match a number of pieces of data extracted from the frame, that is, the number of at least one piece of data included in a framed data group. The extraction unit 33 may supply the extracted deviations of the respective pieces of data to the computing unit 34.

### (((Computing unit 34)))

The computing unit 34 calculates values of the respective pieces of data from the deviations of the respective pieces of data. The computing unit 34 may calculate the respective data values by adding the deviations of the respective pieces of data to the reference value. As a result, the respective data values in the data group obtained by dividing an original data string are calculated. The computing unit 34 may output, to the external device, the data string in which the calculated data values are arranged. For example, the computing unit 34 may output the data string to a data server, a management terminal of the equipment, or the like.

According to the compression apparatus 2 in the communication system 1 described above, the bit width for deviation is decided based on the variation trend of data in the data string, and the frame is generated which includes the bit width ID indicating the bit width for deviation, and the deviations, indicated by the bit width for deviation, of the respective pieces of data in the data group obtained by dividing the data string. Therefore, since the deviations of the respective pieces of data can be indicated by an appropriate bit width according to the variation trend, the amount of data of the frame can be reduced by indicating, by a small bit width, a piece of data with a small variation and a small deviation. In addition, loss of information due to compression can be prevented by indicating, by a large bit width, a piece of data with a large variation and a large deviation. Therefore, it is possible to reduce the amount of data while preventing the loss of information due to compression. This makes it possible to reduce a region for storing the pieces of data and to reduce a communication load.

In addition, since at least one continuous piece of data, a deviation of which falls within the bit width for deviation, is specified from the data string as the data group, the loss of information due to compression can be reliably prevented for each piece of data.

In addition, since the frame is generated which further includes the number of at least one piece of data in the data group, even if the number of at least one piece of data differs depending on the data group, respective deviations in the frame can be specified by the number of at least one piece of data included in the frame. Therefore, original respective data values can be calculated from the deviations of the respective pieces of data.

In addition, since the reference value for the deviations of the respective pieces of data in the data group is the maximum value or the minimum value among the data values in the data group, the deviations of the respective pieces of data can be accurately indicated by the bit width for deviation.

In addition, since the unspecified pieces of data which have not been specified as the data group are specified as the new data group in order starting from the side of the head of the data string, the frames can be generated in sequence starting from the side of the head of the data string.

In addition, since the unspecified piece of data closest to the head in the data string to the piece of data, the deviation of which falls within the bit width for deviation, closest to the end, are specified as the data group, the number of at least one piece of data in each of the data groups can be maximized. Therefore, since a number of the generated frames can be reduced, a number of frame divisions can be reduced, and an overall amount of data of the generated frames can be reduced.

In addition, since the at least one piece of data, the number of which is equal to or smaller than the reference number, is specified as the data group, the number of at least one piece of data in the data group can be made equal to or smaller than the reference number. Therefore, it is possible to prevent the number of at least one piece of data in the data group from becoming too large, causing the frame to become too long.

In addition, since the bit width for deviation is decided for each of the data groups, an appropriate bit width for deviation according to the variation trend of data can be decided for each of the data groups.

In addition, for each of the plurality of bit width candidates, at least one continuous piece of data, a deviation of which falls within the bit width candidate, is specified as the data group candidate, and the data group candidate, for which the compression ratio for a case where the frame is generated is smallest, among the plurality of data group candidates is specified as the data group. Therefore, the frame can be generated by specifying the data group such that the compression ratio is small.

In addition, the bit width candidate, for which the compression ratio for a case where the frame is generated from the corresponding data group candidate is smallest, among the plurality of bit width candidates is decided as the bit width for deviation, and the data group candidate, which corresponds to the bit width candidate decided as the bit width for deviation, among the plurality of data group candidates is specified as the data group. Therefore, the frame can be generated by specifying the bit width for deviation and the data group such that the compression ratio is small.

In addition, since the frame is transmitted from the compression apparatus 2, an amount of communication data can be reduced compared to a case where the data string is transmitted as it is.

In addition, since the frame configuration information indicating the configuration of the frame is transmitted to the apparatus to which the frame is to be transmitted, the frame can be decompressed in the apparatus to which the frame is to be transmitted, to calculate original data.

In addition, according to the decompression apparatus 3 in the communication system 1 described above, the frame is acquired which includes the deviation data string indicating the deviation of at least one piece of data, and the bit width ID indicating the bit width for deviation, the deviations of the respective pieces of data are extracted based on the bit width ID, and the values of the respective pieces of data are calculated. Therefore, the original data can be reproduced from the acquired frame.

### (Relationship between input data and frame)

FIG. 2 shows input data, data groups obtained by dividing the input data, a frame generated for each of the data groups, and a configuration of the frame.

As shown in the present figure, the input data may be divided into a plurality of data groups, and the frame may be generated from each of the data groups. Each frame may include a reference value for deviation, a number of at least one piece of data in the data group, a bit width ID for deviation, and deviations of respective pieces of data. The deviations of the respective pieces of data may be arranged in the same order as the pieces of data in the data group to constitute a deviation data string, and in the present figure, for example, the order of a piece of data corresponding to each of the deviations is indicated by a subscript.

### (Operation)

### ((Operation of compression apparatus 2))

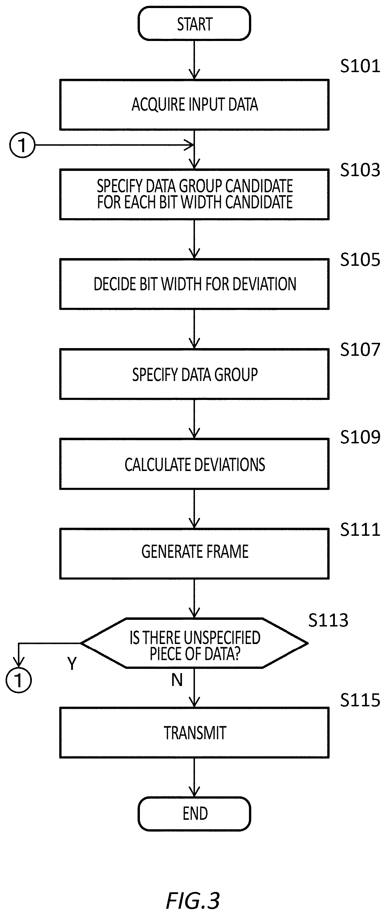

FIG. 3 shows operation of the compression apparatus 2. The compression apparatus 2 generates a frame from input data and transmits the frame to the decompression apparatus 3, by performing processing in steps S101 to S115.

In the step S101, the acquisition unit 21 acquires the input data from an external device. The acquisition unit 21 may acquire the input data from a single external device, or may acquire the input data from a plurality of external devices. If the input data is acquired from the plurality of external devices, the acquisition unit 21 may acquire the input data from each of the external devices while switching connection channels with the external devices. If the input data is acquired from the plurality of external devices, the processing in the steps S103 to S115, which will be described later, may be performed for each of the external devices, that is, for each type of the input data. The acquisition unit 21 may acquire a data string from the input data.

In the step S103, the specification unit 22 specifies, for each of a plurality of bit width candidates, at least one continuous piece of data, a deviation of which falls within the bit width candidate, as a data group candidate. The specification unit 22 may specify an unspecified piece of data closest to a head in the data string to a piece of data, a deviation of which falls within the bit width candidate, closest to an end, as a new data group candidate.

In the step S105, the decision unit 23 decides a bit width for deviation based on a variation trend of data in the data string. In the present embodiment, for example, the decision unit 23 decides the bit width candidate, for which a compression ratio for a case where the frame is generated from a corresponding data group candidate is smallest, among the plurality of bit width candidates as the bit width for deviation.

In the step S107, the specification unit 22 specifies the data group candidate, which corresponds to the bit width candidate decided as the bit width for deviation in the step S105, among a plurality of data group candidates specified in the step S103, as a data group.

In the step S109, the calculation unit 24 calculates, with the bit width for deviation, deviations of respective pieces of data in the data group specified in the step S107. In the present embodiment, for example, the calculation unit 24 may calculate, as the deviations of the respective pieces of data in the data group, the deviations, a reference value for which is a maximum value or a minimum value among data values in the data group.

In the step S111, the generation unit 25 generates the frame including the deviations of the respective pieces of data in the data group, and a bit width ID for deviation. In the present embodiment, for example, the generation unit 25 may generate the frame by arranging a reference value for deviation, a number of at least one piece of data in the data group, the bit width ID for deviation, and the deviations of the respective pieces of data. The generation unit 25 may further generate frame configuration information indicating that the frame includes the reference value for deviation, the number of at least one piece of data in the data group, the bit width ID for deviation, and a deviation data string in this order. If the acquisition unit 21 acquires the input data from the plurality of external devices in step S101, the generation unit 25 may generate the frame configuration information further including a data category or identification information of the external devices.

In the step S113, the specification unit 22 determines whether there is a piece of data unspecified as the data group in the data string. If there is an unspecified piece of data (the step S113; Yes), the processing may move to the step S103 described above. If there is no unspecified piece of data (the step S113; No), the processing may move to the step S115.

In the step S115, the transmission unit 26 transmits the generated frame. The transmission unit 26 may transmit the frame to the decompression apparatus 3. The transmission unit 26 may concatenate a plurality of frames into a compressed object, and then transmit the compressed object to the decompression apparatus 3. Before transmitting the frame, the transmission unit 26 may transmit the frame configuration information to the decompression apparatus 3.

### (Exemplary operation of specification unit 22 and decision unit 23)

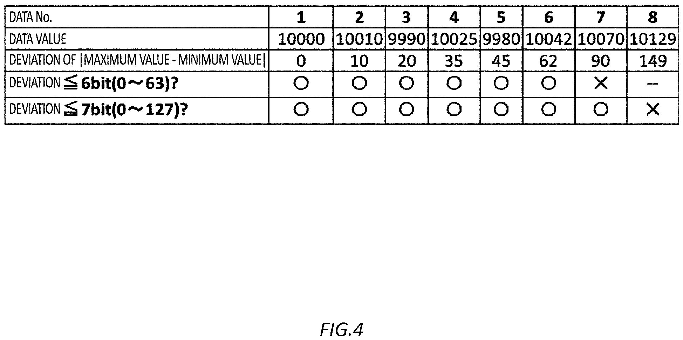

FIG. 4 shows exemplary operation of the specification unit 22. It should be noted that, in the figure, a first row shows numbers of a plurality of pieces of data included in a data string, and a second row shows data values of respective pieces of data included in the data string. In the present figure, first and subsequent pieces of data may be unspecified pieces of data which have not been specified as a data group.

As shown in a third row, the specification unit 22 may calculate deviations of the respective pieces of data. In the present exemplary operation, the specification unit 22 may use a maximum value or a minimum value in a data group candidate as a reference value for deviation, and more specifically, it may use a maximum value or a minimum value among data values included in the data group candidate prior to a piece of data, a deviation of which is to be calculated. As a result, for example, if a deviation of the first piece of data "10000" is calculated, the deviation is set to "0" because there is no piece of data in the data group candidate, and if a deviation of a second piece of data "10010" is calculated, the first piece of data "10000" is present in the data group candidate, and the deviation is set to "10" by using that value as the maximum value or the minimum value. Even if the reference value (the maximum value or the minimum value) is changed as a piece of data is added in the data group candidate, the specification unit 22 may not update a value of a deviation which has been already calculated.

As shown in a fourth row and a fifth row, the specification unit 22 may determine, for 6 bits and 7 bits as bit width candidates, whether deviations exceed the bit width candidates. The specification unit 22 may perform determination for each of the bit width candidates until a deviation is out of the bit width candidates. As a result, an unspecified piece of data closest to a head to a piece of data, a deviation of which falls within the bit width candidates, closest to an end, are specified as the data group candidate. In the present figure, if a bit width candidate is 6 bits, deviations of first to sixth pieces of data fall within the bit width, so the first to sixth pieces of data are specified as the data group candidate. If a bit width candidate is 7 bits, deviations of first to seventh pieces of data fall within the bit width, so the first to seventh pieces of data are specified as the data group candidate.

As described above, when the data group candidate for each of the bit width candidates and a number of at least one piece of data in the data group candidate are specified, the decision unit 23 may calculate a compression ratio for each of the bit width candidates from Equation 1a described below. Compression ratio = (16 + 6 + 2 + number of at least one bit of bit width candidate × number of at least one piece of data) / (16 × number of at least one piece of data) ...

It should be noted that Equation 1a is obtained by substituting specific values into Equation 1 described above. In Equation 1a, "16" is the number of at least one bit of the reference value and a data value, "6" is the number of at least one bit indicating the number of at least one piece of data in the data group candidate, "2" is the number of at least one bit indicating a bit width ID, and "number of at least one piece of data" is the number of at least one piece of data in the data group candidate.

In the present exemplary operation, the compression ratio for a case where the bit width candidate is 6 bits is 0.625, and the compression ratio for a case where the bit width candidate is 7 bits is 0.633. As a result, 6 bits for which the compression ratio is smaller is decided as a bit width for deviation, and the first to sixth pieces of data corresponding to the bit width are specified as the data group.

If a next data group is specified, for seventh and subsequent pieces of data, data group candidates for cases where the bit width candidates are respectively 6 bits and 7 bits may be specified, and a data group for which the compression ratio is smaller may be specified.

### (Exemplary operation of calculation unit 24)

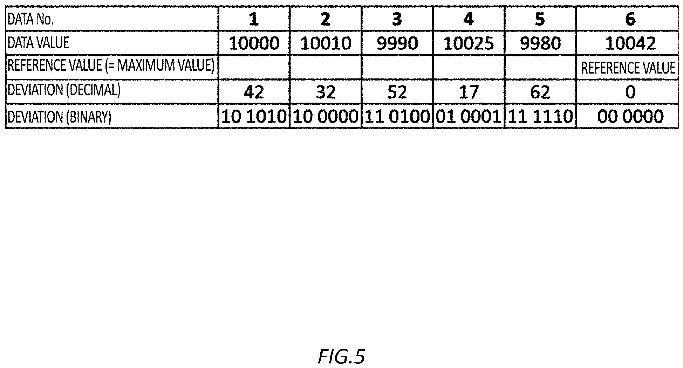

FIG. 5 shows exemplary operation of the calculation unit 24. It should be noted that, in the present exemplary operation, a case will be described in which a deviation is calculated for the data group specified in the exemplary operation shown in FIG. 4. As shown in a fourth row and a fifth row in the figure, the calculation unit 24 may calculate a deviation for each of first to sixth pieces of data in the specified data group. In the present exemplary operation, the deviation is calculated using the sixth piece of data as a reference value.

### (Exemplary operation of generation unit 25)

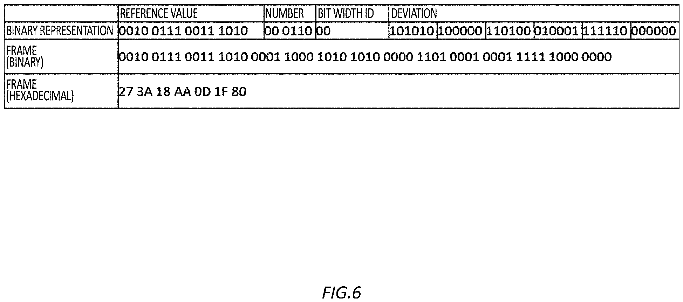

FIG. 6 shows exemplary operation of the generation unit 25. It should be noted that, in the present exemplary operation, a case will be described in which a frame is generated for the data group specified in the exemplary operation shown in FIG. 4. As shown in a second row, the generation unit 25 may calculate a binary representation of a reference value for deviation (in the present exemplary operation, a sixth data value in FIG. 4 and FIG. 5), a binary representation of a number of pieces of data "6" in the data group, a binary representation of a bit width ID, and binary representations of deviations of respective pieces of data. It should be noted that, in the present exemplary operation, the bit width ID of a bit width for deviation "6" is binary "00".

The generation unit 25 may generate a binary frame by concatenating the binary representations of various pieces of information which have been calculated. The generation unit 25 may further generate a hexadecimal representation of the frame by converting the generated binary frame into hexadecimal.

### ((Operation of decompression apparatus 3))

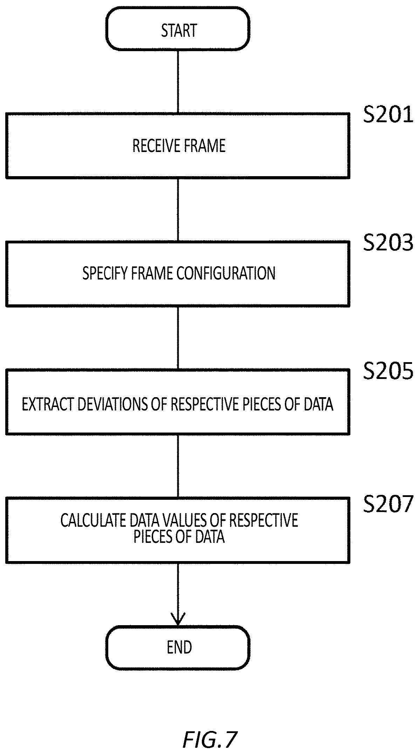

FIG. 7 shows operation of the decompression apparatus 3. The decompression apparatus 3 calculates data values of respective pieces of data from an acquired frame by performing processing in steps S201 to S207. It should be noted that, in the present embodiment, for example, the decompression apparatus 3 will be described as having previously received frame configuration information from the compression apparatus 2.

In the step S201, the acquisition unit 31 acquires the frame. The acquisition unit 31 may receive the frame from the compression apparatus 2.

In the step S203, the frame configuration specification unit 32 specifies a configuration of the frame based on the frame configuration information. The frame configuration specification unit 32 may extract various pieces of information included in the frame (in the present embodiment, for example, a reference value for deviation, a number of at least one piece of data in a data group, a bit width ID for deviation, and a deviation data string), based on a result of specification.

In the step S205, the extraction unit 33 extracts, based on the bit width ID, deviations of the respective pieces of data indicated by a bit width for deviation, from the deviation data string. The extraction unit 33 may specify the bit width corresponding to the bit width ID, and extract deviations of the bit width from the deviation data string.

In the step S207, the computing unit 34 calculates the values of the respective pieces of data from the deviations of the respective pieces of data. The computing unit 34 may calculate respective data values by adding the deviations of the respective pieces of data to the reference value. As a result, the respective data values in the data group obtained by dividing an original data string are calculated.

### (Application example)

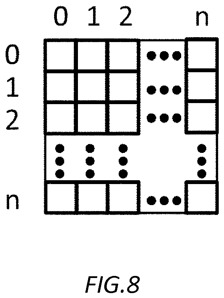

FIG. 8 shows pixels in an image. Image data may have a data value (also referred to as a pixel value) for each of the pixels. It should be noted that numbers in the figure indicate vertical and horizontal coordinates of the image.

The acquisition unit 21 of the compression apparatus 2 according to the present embodiment may acquire a data string in chronological order for each of the pixels from a plurality of pieces of image data captured in order. For example, the acquisition unit 21 may acquire the data string by extracting, from each of the pieces of image data, pieces of data for a pixel indicated by the same coordinates and arranging the pieces of data in order of image-capturing. The plurality of pieces of image data may be images captured by a fixed point camera. The fixed point camera may be a thermography camera, and may use, as its object, a specific device to be continuously monitored. Each pixel value of the image data from the thermography camera may be, for example, signed 8-bit data. The image data may be captured, for example, 16 times a day. In this case, the compression apparatus 2 may generate frames of the data string for one day for each of the pixels, and transmit, to the decompression apparatus 3, a compressed object obtained by concatenating the frames for each of the pixels. A bit width candidate may be 2 to 4 bits, and a number of at least one bit indicating a number of at least one piece of data in a data group may be 4 bits.

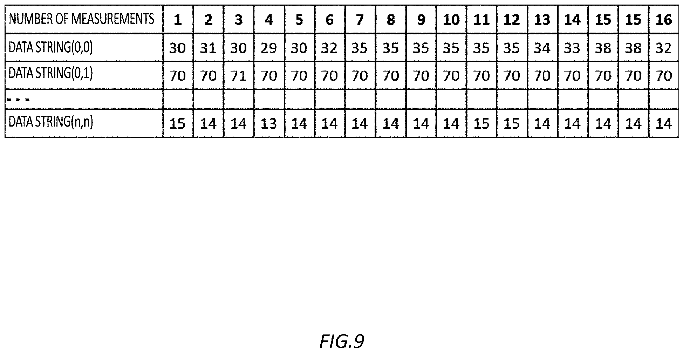

FIG. 9 shows data strings acquired from image data captured by a thermography camera. It should be noted that, in the present figure, an example is shown in which the image data has been captured 16 times in order, and the data strings acquired from respective pixels are shown in second and subsequent rows. Each piece of data included in the data strings may indicate temperature. As shown in this figure, in a thermal image acquired from the thermography camera capturing an image of a fixed point, a variation in data value for each of the pixels is small.

In the case described above, a data string in chronological order is acquired for each of the pixels from a plurality of pieces of image data captured in order, so a compression ratio can be reduced for the data string for a pixel, a pixel value of which does not change. Therefore, the compression ratio of the image data can be reduced.

In addition, since the plurality of pieces of image data are images captured by a fixed point camera, a variation in pixel value of each of the pixels is smaller than a case where the plurality of pieces of image data are images captured by a non-fixed point camera. Therefore, the compression ratio of the image data can be reliably reduced.

In addition, since the fixed point camera is a thermography camera, a compression ratio of thermal image data can be reduced.

### (Another frame)

It should be noted that, in the above embodiment, the generation unit 25 has been described as generating a frame including a reference value for deviation, a number of at least one piece of data in a data group, a bit width ID for deviation, and a deviation data string (also referred to as the frame according to the embodiment, in order to distinguish it from a frame with another configuration), but may generate at least one frame of a simple frame, an uncompressed frame, or a fixed value frame, which will be described later, different from the frame.

### ((Simple frame))

The generation unit 25 may generate another frame which includes at least the number of at least one piece of data in the data group and the bit width ID for deviation and does not include deviations of respective pieces of data (also referred to as a simple frame). The simple frame may further include a representative value in the data group. The representative value may be the same value as the reference value for deviation, and in the present embodiment, for example, both the representative value and the reference value may each be a maximum value or a minimum value in the data group. It is to be noted that the representative value may be a value different from the reference value for deviation, and for example, the representative value may be an average value or a median value in the data group, a head data value, or the like, and the reference value for deviation may be an immediately preceding data value.

Since the simple frame does not include the deviations of the respective pieces of data, it may have a configuration different from that of the frame according to the embodiment. Therefore, when generating the simple frame, the generation unit 25 may generate frame configuration information indicating the configuration of the simple frame. Before transmitting the simple frame, the transmission unit 26 may transmit the frame configuration information to the decompression apparatus 3. The transmission unit 26 may concatenate a plurality of simple frames into a compressed object, and transmit the compressed object to the decompression apparatus 3.

When acquiring the simple frame, the decompression apparatus 3 may extract, with the extraction unit 33, the number of at least one piece of data in the data group and a bit width for deviation from the simple frame. In this case, from a result of extraction, the computing unit 34 may specify a number of at least one continuous piece of data, a deviation of which falls within the bit width for deviation in an original data string, and estimate a degree of data variation. For example, if the bit width for deviation is small and the number of at least one piece of data, a deviation of which falls within the bit width, is large, the computing unit 34 may estimate that the data variation is gradual, and if the bit width for deviation is large and the number of at least one piece of data, a deviation of which falls within the bit width, is small, the computing unit 34 may estimate that the data variation is sharp. If the simple frame further includes the representative value in the data group, the computing unit 34 may estimation a possible range of a data value by using the representative value as a reference. The computing unit 34 may output a result of estimation to a display apparatus (not shown) or the like.

In response to user operation, for the data group for which the simple frame has been transmitted, the decompression apparatus 3 may transmit, to the compression apparatus 2, an instruction signal instructing the compression apparatus 2 to transmit a frame including the deviations of the respective pieces of data. In response to this instruction signal, for the data group for which the simple frame has been transmitted, the compression apparatus 2 may generate a frame including the deviations of the respective pieces of data in the data group, and the bit width ID (for example, the frame according to the embodiment described above), and transmit the frame to the decompression apparatus 3. As result of concatenating the plurality of simple frames into the compressed object and transmitting the compressed object to the decompression apparatus 3, when receiving the instruction signal from the decompression apparatus 3, the compression apparatus 2 may transmit the frame according to the embodiment to the decompression apparatus 3 for each data group for which the plurality of simple frames have been transmitted.

As described above, in the communication system 1 in which the simple frame is generated, the simple frame is generated which includes the number of at least one piece of data in one data group and the bit width ID and does not include the deviations of the respective pieces of data, so a general variation trend of data value can be estimated from the another frame. In addition, in response to an instruction signal from an outside, the frame including the deviations of the respective pieces of data in the one data group and the bit width ID (for example, the frame according to the embodiment described above) is generated, so a detailed variation trend of data value can be confirmed by inputting the instruction signal. Therefore, a storage capacity or a communication load can be reduced compared to a case where a frame including a deviation is always generated.

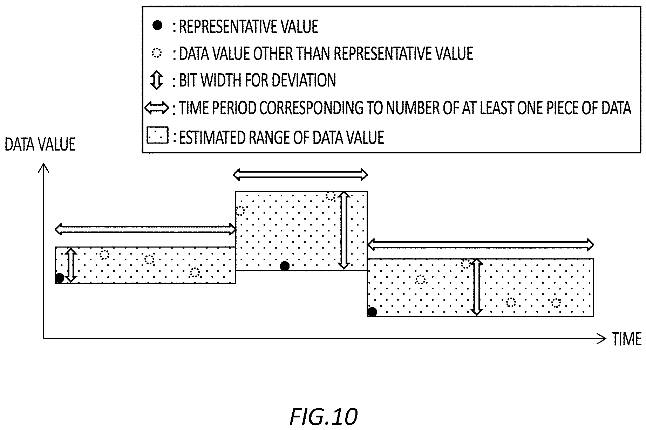

FIG. 10 shows a result of estimation by the computing unit 34. In the figure, a vertical axis represents a measured data value, and a horizontal axis represents time of measurement of the data value. In addition, a black circle plot indicates a representative value, and in the present figure, for example, it indicates a minimum value in a data group. A dashed line plot indicates a data value not shown in a frame. In addition, a vertical outlined arrow indicates a bit width for deviation. It should be noted that, in the present figure, the minimum value in the data group is used as a reference value for deviation. A horizontal outlined arrow indicates a measurement time period corresponding to a number of at least one piece of data in the data group (that is, a result of multiplying the number of at least one piece of data by a preset measurement interval). A shaded range indicates a possible range of the data value for each data group. As shown in the present figure, the computing unit 34 may estimate, as the possible range of the data value, a range of the bit width for deviation by using the representative value as a reference.

### ((Uncompressed frame))

In response to the data group including only a single piece of data being specified, the generation unit 25 may generate a frame including the data value itself (also referred to as an uncompressed frame). The data group including only the single piece of data may be specified by the specification unit 22 if any data value in the data group is used as the reference value for deviation and if a deviation between an unspecified first data value and a second data value does not fall within any bit width candidate. Alternatively or additionally, in response to a compression ratio calculated by the decision unit 23 for each bit width candidate exceeding 1, the data group including only the single piece of data may be specified by the specification unit 22.

The uncompressed frame is one example of a first frame, may include a data value of the single piece of data included in the data group, and identification information of the uncompressed frame (also referred to as an uncompressed frame ID), and in the present embodiment, for example, may include a single data value and the uncompressed frame ID in this order.

The uncompressed frame ID may indicate that a frame including the uncompressed frame ID is the uncompressed frame. The uncompressed frame ID may be a previously assigned value (in the present embodiment, for example, zero). The uncompressed frame ID may be indicated by a bit indicating the number of at least one piece of data in the data group in the frame according to the embodiment (that is, a frame including the reference value for deviation, the number of at least one piece of data in the data group, a bit width ID for deviation, and deviations of respective pieces of data in this order). As a result, also based on frame configuration information indicating the frame according to the embodiment, the frame configuration specification unit 32 of the decompression apparatus 3 which has acquired the uncompressed frame may detect, from the acquired frame, that the number of at least one piece of data in the data group is zero, and identify that the frame is the uncompressed frame. Therefore, when generating the uncompressed frame, the generation unit 25 may not generate the frame configuration information. The computing unit 34 may use a value extracted from the frame as the reference value for deviation based on the frame configuration information of the frame according to the embodiment, as a data value of original data converted into the uncompressed frame.

As described above, in the communication system 1 in which the uncompressed frame is generated, in response to the data group including only the single piece of data being specified, the uncompressed frame including a value of the piece of data and the uncompressed frame ID is generated. Therefore, processing of calculating a deviation can be omitted for the frame including only the single piece of data. In addition, an amount of data can be reduced for a data string including a continuous portion in which single pieces of data continue.

It should be noted that, if the generation unit 25 generates the uncompressed frame and a simple frame, a bit width candidate may be set to a small value (for example, 3 bit or 4 bits) to make it easier to generate the uncompressed frame. In this case, if the deviation between the first data value and the second data value no longer falls within any bit width candidate due to disturbance or the like, the uncompressed frame is automatically generated, so a detailed variation trend of data value can be confirmed using the uncompressed frame.

### ((Fixed value frame))

In response to continuous pieces of data having the same value being specified as the data group, the generation unit 25 may generate a frame indicating that the data value is a fixed value (also referred to as a fixed value frame). Such a data group may be specified by the specification unit 22 in response to pieces of data having the same value (also referred to as a fixed data value) continuing in the data string. For example, in response to the pieces of data having the same value continuing from an unspecified first piece of data, the specification unit 22 may specify, as the data group, the pieces of data continuing. In response to the data value being no longer the fixed data value in the data string, the specification unit 22 may specify data from that and subsequent pieces of data as a new data group. The specification unit 22 may specify the next and subsequent pieces of data as the new data group in response to the pieces of data having the fixed data value continuing, where the number of the pieces of data having the fixed data value is up to the reference number described above.

The fixed value frame is one example of a second frame, may include the fixed data value, the number of at least one piece of data in the data group, and identification information of the fixed value frame (also referred to as a fixed value frame ID), and in the present embodiment, for example, may include the fixed data value, the number of at least one piece of data, and the fixed value frame ID in this order.

The fixed value frame ID may indicate that a frame including the fixed value frame ID is the fixed value frame. The fixed value frame ID may be a previously assigned value. The fixed value frame ID may be indicated by a bit indicating the bit width ID for deviation in the frame according to the embodiment (that is, a frame including the reference value for deviation, the number of at least one piece of data in the data group, a bit width ID for deviation, and the deviations of the respective pieces of data in this order), and may be a value different from the bit width ID associated with each bit width candidate. As a result, also based on the frame configuration information indicating the frame according to the embodiment, the frame configuration specification unit 32 of the decompression apparatus 3 which has acquired the fixed value frame may detect, from the acquired frame, that the bit width ID does not correspond to any bit width candidate, and identify that the frame is the fixed value frame. Therefore, when generating the fixed value frame, the generation unit 25 may not generate the frame configuration information. The computing unit 34 may use a value extracted from the frame as the reference value for deviation based on the frame configuration information of the frame according to the embodiment, as the fixed data value of each piece of data converted into the fixed value frame. The computing unit 34 may generate the data string by arranging the pieces of data having the fixed data value, where the number of the pieces of data having the fixed data value is the number of at least one piece of data extracted from the frame as the number of at least one piece of data in the data group based on the frame configuration information of the frame according to the embodiment.

As described above, in the communication system 1 in which the fixed value frame is generated, in response to the pieces of data having the same value continuing in the data string, the pieces of data continuing are specified as the data group, and the fixed value frame is generated which includes values of the pieces of data, the number of at least one piece of data in the data group, and the fixed value frame ID. Therefore, for a frame including only pieces of data, deviations of which are fixed, it is possible to make the frame short and to reduce a compression ratio, compared to a case where the deviations of the respective pieces of data are included in the frame.

### (Modified example)

It should be noted that, in the above embodiment, the compression apparatus 2 has been described as having the acquisition unit 21, the specification unit 22, and the transmission unit 26, but may not have any one of these units. If the compression apparatus 2 does not have the acquisition unit 21, the decision unit 23 may decide a bit width for the data string previously stored in the compression apparatus 2. If the compression apparatus 2 does not have the specification unit 22, the data group may be previously divided by a number of at least one unit in the data string, or the decision unit 23 or the like may divide the data string by the number of at least one unit in the data string. If the compression apparatus 2 does not have the transmission unit 26, the generated frame may be stored in a storage unit (not shown).

In addition, the acquisition unit 21 has been described as acquiring the data string from the external device, but may acquire the data string generated in the compression apparatus 2. For example, the compression apparatus 2 may include therein a sensor generating the data string of measurement data, or the like. In this case, the compression apparatus 2 as a whole may constitute a sensor apparatus.

In addition, the frame according to the embodiment has been described as including the number of at least one piece of data in the data group, but may include, in addition to the number of at least one piece of data or instead of the number of at least one piece of data, information indicating an end position of a deviation at an end among the deviations of the respective pieces of data. Even in this case, each of the deviations in the frame can be specified in the decompression apparatus 3, so original data values can be calculated from the deviations of the respective pieces of data.

In addition, the calculation unit 24 has been described as calculating, as the deviations, results of subtracting one of the reference value or the data values from another, but may calculate, as the deviations of the respective pieces of data in the data group, the deviations of the respective pieces of data obtained through division by a preset natural number. For example, the calculation unit 24 may calculate, as the deviations of the respective pieces of data, deviations of values D₁/N, D₂/N, ... Dₙ/N obtained by dividing data values D₁, D₂, ... Dₙ of the respective pieces of data in the data group by a natural number N. For example, the calculation unit 24 may set the reference value for deviation as D₁/N, and set the deviations of the respective pieces of data as (D₁/N - D₁/N), (D₁/N - D₂/N), ... (D₁/N - Dₙ/N). Alternatively, the calculation unit 24 may calculate, as the deviations of the respective pieces of data, deviations of values {(D₁ + 1)/N}, {(D₂ + 1)/N}, ... {(Dₙ + 1)/N} obtained by adding 1 to the data values D₁, D₂, ... Dₙ of the respective pieces of data in the data group and dividing the results by the natural number N. For example, the calculation unit 24 may set the reference value for deviation as {(D₁ + 1)/N}, and set the deviations of the respective pieces of data as {(D₁ + 1)/N - (Di + 1)/N}, {(D₂ + 1)/N - (Di + 1)/N}, ... {(Dₙ + 1)/N - (Di + 1)/N}. The natural number N may be a power of 2, such as 2, 4, or 8, for example. In response to the compression ratio calculated by the decision unit 23 for each bit width candidate being larger than 1, the calculation unit 24 may calculate deviations of pieces of data obtained through division as described above. If the deviations of the pieces of data obtained through division are calculated, the generation unit 25 may generate a frame including the above natural number as a divisor, the deviations of the pieces of data divided for the respective pieces of data in the data group, and the bit width ID. This makes it possible to reduce numbers of digits of the deviations and to reduce a length of the frame. If such a frame is acquired, the decompression apparatus 3 may calculate the original data values by multiplying respective deviations by the natural number included in the frame as the divisor. If the frame includes the deviations of the pieces of data obtained through division, conversion from the data group to the frame may be irreversible conversion, so the calculated data values may be approximation values of the original data values. It should be noted that the frame including the deviations of the pieces of data obtained through division may further include the reference value for deviation and the number of at least one piece of data in the data group.

In addition, the specification unit 22 has been described as specifying data group candidates from an unspecified piece of head data and specifying any one of the data group candidates, for which the compression ratio is smallest, as the data group, but may specify the data group candidate by using another approach. For example, the specification unit 22 may specify a first data group candidate from the unspecified piece of head data. The specification unit 22 may further specify a second data group candidate from the unspecified piece of head data for a case where the first data group candidate is specified as the data group. In this manner, the specification unit 22 may further specify an n-th data group candidate from the unspecified piece of head data for a case where a specified (n - 1)-th data group candidate (n is an integer equal to or greater than 2) is specified as the data group. Then, the specification unit 22 may specify, as the data group, respective data group candidates included in a combination of data group candidates, for which an overall compression ratio is smallest, among a plurality of combinations of data group candidates from the first data group candidate to the n-th data group candidate which are continuous. Additionally or alternatively, if a plurality of pieces of data, which are second and subsequent pieces of data, in a data group candidate continue with the same data value (also referred to as the fixed data value), the specification unit 22 may set the data group candidate to be up to immediately before the continuous portion. This makes it possible to convert the plurality of pieces of data continuing with the fixed data value into the fixed value frame.

In addition, the decompression apparatus 3 has been described as having the frame configuration specification unit 32, but if only the frame according to the embodiment is generated in the compression apparatus 2, the decompression apparatus 3 may not have the frame configuration specification unit 32.

Various embodiments of the present invention may be described with reference to flowcharts and block diagrams, where blocks may represent (1) stages of processes in which operations are executed or (2) sections of apparatuses responsible for executing operations. Certain stages and sections may be implemented by dedicated circuit, programmable circuit supplied together with computer readable instructions stored on computer readable media, and/or processors supplied together with computer readable instructions stored on computer readable media. Dedicated circuit may include digital and/or analog hardware circuits, and may include integrated circuits (IC) and/or discrete circuits. The programmable circuit may include a reconfigurable hardware circuit including logical AND, logical OR, logical XOR, logical NAND, logical NOR, and another logical operation, a memory element or the like such as a flip-flop, a register, a field programmable gate array (FPGA) and a programmable logic array (PLA), or the like.

Computer readable medium may include any tangible device that can store instructions for execution by a suitable device, and as a result, the computer readable medium having instructions stored therein includes an article of manufacture including instructions which may be executed to create means for executing operations designated in the flowcharts or block diagrams. Examples of the computer readable medium may include an electronic storage medium, a magnetic storage medium, an optical storage medium, an electromagnetic storage medium, a semiconductor storage medium, and the like. More specific examples of the computer readable medium may include a FLOPPY (registered trademark) disk, a diskette, a hard disk, a random access memory (RAM), a read only memory (ROM), an erasable programmable read only memory (EPROM or a flash memory), an electrically erasable programmable read only memory (EEPROM), a static random access memory (SRAM), a compact disc read only memory (CD-ROM), a digital versatile disk (DVD), a BLU-RAY (registered trademark) disk, a memory stick, an integrated circuit card, and the like.

Computer readable instructions may include either a source code or an object code described in any combination of one or more programming languages, where the source code or the object code includes a conventional procedural programming language, and the conventional procedural programming language may be assembler instructions, instruction-set-architecture (ISA) instructions, machine instructions, machine dependent instructions, microcode, firmware instructions, state-setting data, or an object-oriented programming language such as SMALLTALK (registered trademark), JAVA (registered trademark), C++, etc., and programming languages, such as the "C" programming language or similar programming languages.

The computer readable instructions may be provided to a processor or a programmable circuit of a programmable data processing apparatus such as a computer locally or via a local area network (LAN) or a wide area network (WAN) such as the Internet or the like, and the processor or the programmable circuit may execute the computer readable instructions to create means for executing operations designated in the flowcharts or block diagrams. Here, the computer may be a computer such as a personal computer (PC), a tablet computer, smartphone, a work station, a server computer, a general purpose computer or the like, or a special purpose computer or the like, or may be a computer system in which a plurality of computers are connected. Such computer system in which the plurality of computers are connected is also referred to as a distributed computing system, and is a computer in a broad sense. In a distributed computing system, a plurality of computers collectively execute a program by each of the plurality of computers executing part of the program, and passing data during the execution of the program among the computers as needed.

Examples of the processor include a computer processor, a central processing unit (CPU), a processing unit, a microprocessor, a digital signal processor, a controller, a microcontroller, and the like. The computer may include one processor or a plurality of processors. In a multi-processor system including a plurality of processors, the plurality of processors collectively execute a program by each of the processors executing part of the program, and passing data during the execution of the program among the processors as needed. For example, in execution of multiple tasks, each of the plurality of processors may execute one portion of each task pieces by pieces by performing task-switching for each time slice. In this case, which portion of one program each processor is to execute dynamically changes. Which portion of the program each of the plurality of processors is to execute may be statically determined by multiprocessor-aware programming.

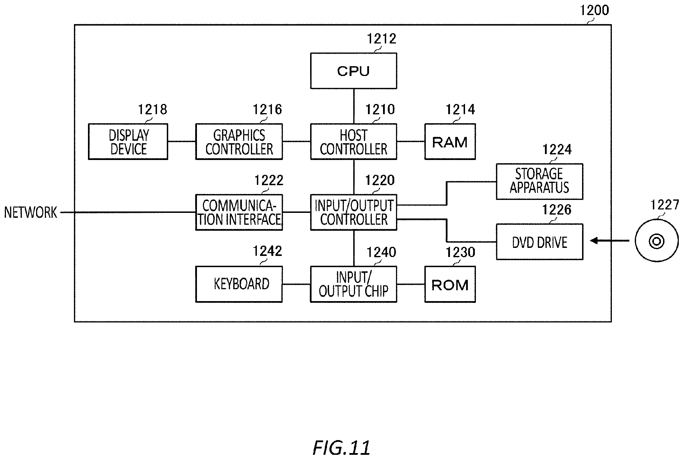

FIG. 11 shows an example of a computer 1200 in which a plurality of aspects of the present invention may be entirely or partially embodied. Programs installed in the computer 1200 can cause the computer 1200 to function as operations associated with the apparatus according to the embodiments of the present invention or one or more sections of the apparatus, or can cause the computer 1200 to execute the operations or the one or more sections, and/or can cause the computer 1200 to execute a process according to the embodiments of the present invention or stages of the process. Such programs may be executed by a CPU 1212 in order to cause the computer 1200 to execute specific operations associated with some or all of the blocks in the flowcharts and block diagrams described in the present specification.

The computer 1200 according to the present embodiment includes the CPU1212, an RAM 1214, a graphics controller 1216, and a display device 1218, which are mutually connected by a host controller 1210. The computer 1200 also includes a communication interface 1222, a storage apparatus 1224 such as a hard disk drive, a DVD-ROM drive 1226, and an input/output unit such as an IC card drive, which are connected to a host controller 1210 via an input/output controller 1220. The computer also includes legacy input/output units such as a ROM 1230 and a keyboard 1242, which are connected to the input/output controller 1220 via an input/output chip 1240.

The CPU 1212 operates in accordance with the programs stored in the ROM 1230 and the RAM 1214, thereby controlling each unit. The graphics controller 1216 acquires image data generated by the CPU 1212 on a frame buffer or the like provided in the RAM 1214 or in the graphics controller 1216 itself, so that the image data is displayed on the display device 1218.

The communication interface 1222 communicates with another electronic device via a network. The storage apparatus 1224 stores the programs and data used by the CPU 1212 in the computer 1200. The DVD-ROM drive 1226 reads the programs or the data from the DVD-ROM 1227, and provides the programs or the data to the storage apparatus 1224 via the RAM 1214. The IC card drive reads the programs and the data from an IC card, and/or writes the programs and the data to the IC card.

The ROM 1230 stores therein boot programs or the like executed by the computer 1200 at the time of activation, and/or programs depending on hardware of the computer 1200. The input/output chip 1240 may also connect various input/output units to the input/output controller 1220 via a parallel port, a serial port, a keyboard port, a mouse port or the like.

Programs are provided by a computer readable medium such as the DVD-ROM 1227 or the IC card. The programs are read from the computer readable medium, are installed in the storage apparatus 1224, the RAM 1214, or the ROM 1230, which is also an example of the computer readable medium, and are executed by the CPU 1212. Information processing described in these programs is read by the computer 1200, and provides cooperation between the programs and the various types of hardware resources described above. The apparatus or method may be configured by achieving operations or processing of information in accordance with use of the computer 1200.

For example, if a communication is executed between the computer 1200 and an external device, the CPU 1212 may execute a communication program loaded in the RAM 1214 and instruct the communication interface 1222 to perform communication processing based on processing described in the communication program. The communication interface 1222, under the control of the CPU 1212, reads transmission data stored in a transmission buffering region provided in a recording medium such as the RAM 1214, the storage apparatus 1224, the DVD-ROM 1227, or the IC card, transmits the read transmission data to the network, or writes reception data received from the network to a reception buffering region or the like provided on the recording medium.

In addition, the CPU 1212 may cause all or necessary portion of a file or a database stored in an external recording medium such as the storage apparatus 1224, a DVD-ROM drive 1226 (the DVD-ROM 1227), the IC card, or the like, to be read by the RAM 1214, and execute various types of processing on the data on the RAM 1214. Next, the CPU 1212 writes the processed data back in the external recording medium.

Various types of information, such as various types of programs, data, tables, and databases, may be stored in the recording medium to undergo information processing. The CPU 1212 may execute, on the data read from the RAM 1214, various types of processing including various types of operations, information processing, conditional judgement, conditional branching, unconditional branching, information search/replacement, or the like described throughout the present disclosure and designated by instruction sequences of the programs, to write the results back to the RAM 1214. In addition, the CPU 1212 may search for information in a file, a database, or the like in the recording medium. For example, when a plurality of entries, each having an attribute value of a first attribute associated with an attribute value of a second attribute, are stored in the recording medium, the CPU 1212 may search for, out of the plurality of entries, an entry with the attribute value of the first attribute designated that meets a condition, and read the attribute value of the second attribute stored in said entry, thereby acquiring the attribute value of the second attribute associated with the first attribute satisfying a predetermined condition.

The programs or software modules described above may be stored in a computer readable medium on the computer 1200 or near the computer 1200. In addition, a recording medium such as a hard disk or a RAM provided in a server system connected to a dedicated communication network or the Internet can be used as the computer readable medium, so that the programs are provided to the computer 1200 via the network.

While the present invention has been described by way of the embodiments, the technical scope of the present invention is not limited to the scope described in the above embodiments. It is apparent to persons skilled in the art that various modifications or improvements can be made to the above embodiments. It is also apparent from description of the claims that the embodiments to which such modifications or improvements are made may be included in the technical scope of the present invention.

It should be noted that each process of the operations, procedures, steps, stages, and the like performed by the apparatus, system, program, and method shown in the claims, specification, or drawings can be executed in any order as long as the order is not indicated by "prior to", "before", or the like and as long as the output from a previous process is not used in a later process. Even if the operation flow is described using phrases such as "first" or "next" for the sake of convenience in the claims, specification, or drawings, it does not necessarily mean that the process must be performed in this order.

### EXPLANATION OF REFERENCES

1: communication system
2: compression apparatus
3: decompression apparatus
21: acquisition unit
22: specification unit
23: decision unit
24: calculation unit
25: generation unit
26: transmission unit
31: acquisition unit
32: frame configuration specification unit
33: extraction unit
34: computing unit
1200: computer
1210: host controller
1212: CPU
1214: RAM
1216: graphics controller
1218: display device
1220: input/output controller
1222: communication interface
1224: storage apparatus
1226: DVD-ROM drive
1227: DVD-ROM
1230: ROM
1240: input/output chip
1242: keyboard.

## Claims

1. A compression apparatus comprising:
a decision unit which decides, based on a variation trend of data in a data string, a bit width indicating a deviation of data;
a calculation unit which calculates, with the bit width, deviations of respective pieces of data in a data group obtained by dividing the data string; and
a generation unit which generates a frame including: the deviations of the respective pieces of data in the data group; and information indicating the bit width.

2. The compression apparatus according to claim 1, further comprising a specification unit which specifies, from the data string, at least one continuous piece of data, a deviation of which falls within the bit width, as the data group.

3. The compression apparatus according to claim 2, wherein
the generation unit generates the frame further including at least one of: a number of at least one piece of data in the data group; or information indicating an end position of a deviation at an end among the deviations of the respective pieces of data.

4. The compression apparatus according to claim 2 or 3, wherein
a reference value for deviations of respective pieces of data in a data group is a maximum value or a minimum value among data values in the data group.

5. The compression apparatus according to any one of claims 2 to 4, wherein
the specification unit specifies, in order starting from a side of a head of the data string, unspecified pieces of data which have not been specified as the data group, as a new data group.

6. The compression apparatus according to claim 5, wherein
the specification unit specifies an unspecified piece of data closest to the head in the data string to a piece of data, a deviation of which falls within the bit width, closest to an end, as the new data group.

7. The compression apparatus according to claim 6, wherein
the generation unit generates another frame including a number of at least one piece of data in one data group being the data group, and the information indicating the bit width and not including deviations of respective pieces of data, and generates, in response to an instruction signal from an outside, the frame including: deviations of respective pieces of data in the one data group; and the information indicating the bit width.

8. The compression apparatus according to claim 6, wherein
in response to the data group including only a single piece of data being specified, the generation unit generates, as a first frame different from the frame, the first frame including: a value of the single piece of data; and identification information of the first frame.

9. The compression apparatus according to any one of claims 2 to 8, wherein
in response to pieces of data having a same value continuing in the data string, the specification unit specifies, as the data group, the pieces of data continuing, and
in response to continuous pieces of data having a same value being specified as the data group, the generation unit generates, as a second frame different from the frame, the second frame including: values of the continuous pieces of data having the same value; a number of at least one piece of data in the data group; and identification information of the second frame.

10. The compression apparatus according to any one of claims 2 to 9, wherein
the decision unit decides the bit width for each data group.

11. The compression apparatus according to claim 10, wherein
the specification unit:
specifies, for each of a plurality of bit width candidates, at least one continuous piece of data, a deviation of which falls within the bit width candidate, as a data group candidate; and
specifies the data group candidate, for which a compression ratio for a case where the frame is generated is smallest, among a plurality of data group candidates including the data group candidate, as the data group.

12. The compression apparatus according to claim 1, wherein
the calculation unit calculates, as the deviations of the respective pieces of data in the data group, deviations of respective pieces of data obtained through division by a preset natural number, and
the generation unit generates a frame including: the natural number; the deviations of the respective pieces of data in the data group; and the information indicating the bit width.

13. The compression apparatus according to claim 1, further comprising an acquisition unit which acquires the data string in chronological order for each pixel from a plurality of pieces of image data captured in order.

14. A compression method comprising:
deciding, based on a variation trend of data in a data string, a bit width indicating a deviation of data;
calculating, with the bit width, deviations of respective pieces of data in a data group obtained by dividing the data string; and
generating a frame including: the deviations of the respective pieces of data in the data group; and information indicating the bit width.

15. A program which, when executed by a computer, causes the computer to function as:
a decision unit which decides, based on a variation trend of data in a data string, a bit width indicating a deviation of data;
a calculation unit which calculates, with the bit width, deviations of respective pieces of data in a data group obtained by dividing the data string; and
a generation unit which generates a frame including: the deviations of the respective pieces of data in the data group; and information indicating the bit width.
